# EUROPEAN PATENT SPECIFICATION

(11) **EP 4 302 057 B1**
(45) Date of publication and mention of the grant of the patent: **03.07.2024**
(21) Application number: 22729560.7
(22) Date of filing: 17.05.2022
(51) Int. Cl.: G01K 1/14, G01K 1/16, G01K 7/16, G01K 7/02, H01L 23/00

(54) **POWER MODULE AND METHOD FOR PRODUCING A POWER MODULE**
LEISTUNGSMODUL UND VERFAHREN ZUR HERSTELLUNG EINES LEISTUNGSMODULS
MODULE DE PUISSANCE ET PROCÉDÉ DE FABRICATION D'UN MODULE DE PUISSANCE

(43) Date of publication of application: 10.01.2024
(73) Proprietor: Hitachi Energy Ltd, 8050 Zürich (CH)
(72) Inventor: SANTOLARIA, Lluis, 4600 Olten (CH); MALEKI, Milad, 5417 Untersiggenthal (CH)
(74) Representative: Epping - Hermann - Fischer
(86) International application number: PCT/EP2022/063279
(87) International publication number: WO 2023/222195

(56) References cited:
- WO-A1-2020/032871
- DE-A1-102020 207 708
- US-A1- 2014 131 767

## Description

The present disclosure relates to a power module and a method for producing a power module.

Document US 2014/131767 A1 discloses a dual compartment semiconductor package with temperature sensor.

There is a need for an improved power module, for example a power module that enables faster and/or more reliable detection of malfunctions, like overheating. Furthermore, there is a need for an improved method for producing a power module.

Embodiments of the disclosure relate to an improved power module. Further embodiments of the disclosure relate to an improved method for producing a power module.

Firstly, the power module is specified.

According to the present invention, the power module comprises a substrate, a power semiconductor device moutned on and electrically connected to the substrate, and a connection element for electrically connecting the power semiconductor device. Furthermore, the power module comprises a sensing element for measuring a measurand. A bond section of the connection element is bonded to and electrically connected with the power semiconductor device. The sensing element is mounted on the connection element and spaced from the bond section. The bond section of the connection element is bonded to a contact side of the power semiconductor device in a bond region, wherein the contact side is a top contact side facing away from the substrate. The sensing element is mounted on the connection element such that, in plan view of the contact side, the sensing element is spaced from the bond region.

The connection element comprises a flat section running parallel to the contact side. The sensing element is mounted on the flat section and the flat section is arranged at a greater height than the bond section with respect to a top side of the substrate.

Overheating of power semiconductor devices, also referred to as power semiconductor chips or simply chips for short, in a power module can be detected by the use of temperature sensors, which are implemented in the power module. Overheating can be a consequence of degradation of joining connections or a loss of cooling capability or of a malfunction of the power semiconductor devices. For the detection, simple temperature sensing elements like NTCs, PTCs and/ or platinum-based resistors, like PT100 or PT1000 resistors, can be used. One or more of these sensors are typically positioned in the direct neighborhood of the heat generating power semiconductor device(s). The sensor readings follow the temperature behavior of the power semiconductor device better if the one or more sensing elements are placed as near as possible to the power semiconductor device(s).

Usually, however, the sensing element is placed on a separate metallization pattern of a substrate next to the power semiconductor device. Here the sensing element is not directly linked to the junction temperature of the power semiconductor device so that a comparably long thermal path must be considered and a transfer function with corresponding errors and uncertainties is needed to determine the junction temperature from the sensor readings. Additionally, there is a time delay between the true chip temperature and the sensor reading.

An alternative that makes it possible to obtain direct and exact data is the placement of the sensing element on top of the heat generating power semiconductor device. However, on the one hand this alternative takes space from the area used for bond connections, which can be particularly critical on SiC chips due to the small chip sizes and higher current densities. On the other hand, when considering a mounting of the sensing element on top of the bond section of the connection element, the mounting may be very difficult or even impossible due to geometrical and/or mechanical features of the bond connection between wire bond, ribbon or clip and the chip, as they often have a curved shape. A further alternative would be a chip with an integrated sensor or sensing element. However, this is rarely the case.

The inventors of the present invention recognized that mounting at least one sensing element on a connection element which is bonded to the chip provides good sensor readings and short response times, at least compared with the situation, where the sensing element is mounted on a substrate metallization pattern. The region of the connection element spaced from the bond section at which the connection element is actually bonded to the chip usually provides sufficient space for mounting the sensing element but still results in sufficiently good and fast sensor readings. This is particularly due to the proximity of the sensing element to the chip. In the case of a temperature sensor, the short response times are, inter alia, due to the good heat conduction of the connection element and the comparably short thermal path. Moreover, no additional space on the substrate is needed for the sensing element with this location of the sensing element. Therefore, the position of the sensing element potentially allows for the reduction of the module size or there is more space for power semiconductor device, which is related to higher current capability. This position is applicable for small and big chips. Particularly for small chips, where space on the chip or on the top surface of the bond section is limited or not available, the position on the connection element, but spaced from the bond section, is beneficial. Last but not least, with the placement of the sensing element on the connection element, information about interface degradation of the bond connections between power semiconductor device and substrate and between connection element and power semiconductor device, respectively, can be achieved.

The connection element is, for example, based on metal. For example, the connection element comprises or consists one of: Cu, Al, Au, Ag, any alloy of these metals. By way of example, the connection element is configured to carry a current of at least 1A or at least 10 A or at least 100 A.

The connection element, namely a bond section thereof, is bonded to the power semiconductor device, for example to a contact element of the power semiconductor device. Thus, a firm bond is formed between the power semiconductor device and the connection element. For example, the connection element is glued or soldered or sintered or welded to the power semiconductor device. Therefore, at most glue or solder material or sinter material is arranged between the connection element and the power semiconductor device. The connection element may be formed contiguously. For example, the connection element is formed in one piece.

The bond section of the connection element is a portion configured to be bonded to another element. The bond section may be a foot or a stitched section or a punched section of the connection element. The connection element may comprise one or more such bond sections. The bond section is, for example, defined as the region of the connection element at which one or more joints between the connection element and the power semiconductor device are formed.

The sensing element is configured to measure a measurand, like a physical property of the power semiconductor device or a physical property of the environment around the power semiconductor device. The sensing element can be a sensor or a part of a sensor, namely the first element of a measuring chain, i.e. the part of the sensor that responds directly to a measurand. Such a sensing element is also known as a transducer. The sensor itself may comprise, besides this first element, further components of the measuring chain.

The sensing element may be electrically connected to the connection element or may be electrically isolated from the connection element. The sensing element may be electrically connected to one or more further elements of the power module, for example by means of wire bonding.

The sensing element is mounted on the connection element, for example, firmly bonded to the connection element. For instance, the sensing element is bonded to the connection element by means of soldering, gluing, sintering or any other applicable bonding/joining method. Thereby, the sensing element is spaced from the bond section. In the case that the connection element comprises two or more bond sections, the sensing element is, for example, spaced from each of these bond sections.

A distance, i.e. shortest connection, between the sensing element and the bond section or each bond section is, for example, at least 50 µm or at least 100 µm and/or at most 15 mm or at most 5 mm or at most 1 mm. For example, the length of a shortest path along the connection element connecting sensing element and the bond section is at least 50 µm or at least 100 µm and/or at most 15 mm or at most 5 mm or at most 1 mm. A distance between the sensing element and the connection element due to an optional connection material therebetween is, for example, at most 200 µm or at most 50 µm or at most 10 µm or at most 5 µm.

Besides the power semiconductor device, the connection element and the sensing element mentioned so far, the power module may comprise one or more further power semiconductor devices, one or more further connection elements and/or one or more further sensing elements. By way of example, one or more further connection elements are bonded and electrically connected to the power semiconductor device. One or more further sensing elements may be mounted on the connection element and/or on the further connection elements. All features disclosed so far and in the following for one power semiconductor device, one connection element and one sensing element are also disclosed for all further power semiconductor devices, connection elements and sensing elements, respectively.

According to a further embodiment, the sensing element is a temperature sensing element for measuring a temperature. The temperature measured with the help of the sensing element is characteristic for the temperature of the power semiconductor device and/or its time dependency, since the sensing element is mounted in its vicinity and the power semiconductor device is the main heat source of a power module.

Alternatively, the sensing element could be configured for measuring a different measurand, like moisture, humidity, current, voltage, pressure, magnetic field, vibrations and so on. The sensing element could be a Hall sensor, for example.

According to at least one embodiment, the connection element is a ribbon or a wire or a clip or a terminal.

A terminal is an element which is configured for an external electrical connection of the power module, i.e. for an electrical connection of the power module to an external component of an application. The terminal is, for example, a sheet-like, rigid element, like a busbar or a leadframe. The connection element may comprise a main body and at least one terminal foot. The terminal foot constitutes a bond section of the terminal for bonding the terminal. Between the main body and a terminal foot, the terminal may comprise a kink of, for example, 90°. Each terminal foot, or the whole terminal, may have a width of at least 1 mm and/or at most 15 mm. A thickness of each terminal foot or of the whole terminal is at least 0.15 mm and/or at most 2.0 mm or at most 1.5 mm, for example.

A clip is herein understood to be a rigid, sheet-like structure, e.g. a stamped and pre-bend structure. A clip is usually used to electrically connect two elements of the power module. For example, the clip comprises at least two clip feet or end portions connected by a main body of the clip. The clip feet or end portions constitute bond sections of the clip for bonding the clip. Between the main body and each clip foot there may be a kink. The widths and/or thicknesses may be the same as specified for the terminal.

A ribbon is a flexible or bendable structure. A ribbon may have a width of at least 0.5 mm and/or at most 15 mm. A thickness of the ribbon may be at least at least 20 µm and/or at most 2 mm. For example, the width is larger than the thickness, e.g. at least by a factor of 2.

The above-mentioned dimensions of the connection element enable a good heat conduction from the power semiconductor device to the sensing element. At the same time, the dimensions are such that the connection element itself does not have too large a surface since this would lead to a strong cooling of the connection element. On the other hand, the dimensions are large enough that high currents can be transported without excessive heating of the connection element due to the passing current. Thus, the position on connection element where the sensing element is mounted reflects the actual temperature of the power semiconductor device very well.

The bond section of the connection element is bonded to a contact side of the power semiconductor device. The bond connection between the bond section and the contact side is established within a bond region. For example, within the bond region, there are one or more joints, like welding joints, soldering joints or gluing joints, between the bond section and the contact side. The bond region is, for example, defined as and/or restricted to the region over which joints between the connection element and the power semiconductor device are formed. A joint is herein understood to be an area over which a firm bond or material bond, respectively, is realized between two elements. In the case of welding a joint is, for example, the area where material is molten.

The contact side may, at least partially, be formed by a contact element of the power semiconductor device or by the surface of such a contact element, respectively. The contact element may be formed of metal e.g. comprising aluminum, copper, silver, or a corresponding alloy. For example, the bond connection between the bond section and the power semiconductor device is between the bond section and the contact element.

The sensing element is mounted on the connection element such that, in plan view of the contact side, the sensing element is spaced form the bond region, i.e. the sensing element does not overlap with the bond region in this plan view. However, in plan view of the contact side, the sensing element is close to the bond region. For example, in this plan view, a lateral distance between the bond region and the sensing element is at least 1 mm or at least 100 µm. In the case of the connection element having several bond sections each bonded to an element in a bond region, the sensing element does not, for example, overlap with any of these bond regions in plan view.

By way of example, in plan view of the contact side, the sensing element is spaced from the bond region by at least the thickness of the connection element or at least two times or at least three times the thickness of the connection element.

According to a further embodiment, in plan view of the contact side, the sensing element is spaced from the power semiconductor device and/or from the active region of the power semiconductor device. Thus, the sensing element does not overlap with the power semiconductor device and/or its active region. For example, in the plan view of the contact side, the sensing element is spaced from the power semiconductor device and/or the active region thereof by at least 1 mm or at least 100 µm.

The power module further comprises a substrate. The substrate may have a top metallization for mounting of components and for the electrical connection to components of the power module. Furthermore, the substrate may have a bottom metallization. In between the top metallization and the bottom metallization there may be an electrically isolating layer. The substrate may be an insulated metal substrate (IMS) with an electrically insulating resin layer sandwiched between the top metallization and the bottom metallization. Alternatively, the substrate may be an active metal bracing or a direct bonded copper (DBC) or direct bonded aluminum (DBA) substrate with a ceramic isolating sheet between the top and bottom metallization.

The power semiconductor device is mounted on and electrically connected to the substrate. For example, the power semiconductor device is mounted on and electrically connected to the top metallization of the substrate, for instance by means of soldering, gluing or sintering.

The contact side of the power semiconductor device is a top contact side facing away from the substrate. Thus, a bottom side of the power semiconductor device opposite to the top contact side may face and may be electrically connected to the substrate.

A surface of the connection element on which the sensing element is mounted may face away from the substrate. Alternatively, the surface may face towards the substrate.

The connection element comprises a flat section. "Flat section" means that a surface of this section is flat within the limits of manufacturing tolerances. The flat section and, optionally, its surface runs parallel to the contact side and, optionally, obliquely or parallel to a top side of the substrate on which the power semiconductor device is mounted. Parallel herein means essentially parallel, for example with a maximum deviation from exactly parallel of at most 10°.

The sensing element is mounted on the flat section of the connection element, i.e. the flat surface thereof. This makes mounting of the sensor particularly easy.

The flat section is at a different height than the bond section with respect to a top side of the substrate and/or with respect to the contact side. For example, with respect to the top side of the substrate or the contact side of the power semiconductor device, the flat section is arranged at a greater height than the bond section. The height difference may be at least 50 µm or at least 100 µm or at least 1 mm.

According to a further embodiment, the connection element electrically connects the power semiconductor device with one or more further elements of the power module. For example, in plan view of the contact side of the power semiconductor device, the sensing element is then arranged between the power semiconductor device and the further element.

According to a further embodiment, the further element is a further power semiconductor device or a substrate. It may be the same substrate on which the power semiconductor device is mounted or a further substrate which is different from the substrate on which the power semiconductor device is mounted. The further element may be a further power semiconductor device on a further substrate. The further element could also be a terminal.

According to a further embodiment, the power semiconductor device is a switching element, like a transistor or a thyristor or a diode.

According to a further embodiment, the power semiconductor device is a MOSFET or an IGBT or a MISFET or a JFET or a HEMT.

According to at least one embodiment, the connection element is electrically connected to a main electrode of the power semiconductor device, like a source/emitter electrode or a drain/collector electrode. Alternatively, the connection element could be electrically connected to a gate electrode of the power semiconductor device.

According to a further embodiment, the power semiconductor device is based on at least one of: silicon, silicon carbide, gallium nitride. That is, a semiconductor body of the power semiconductor device is based on one of these semiconductors.

According to a further embodiment, the sensing element is a resistive element. The sensing element may have a positive resistance behavior (Positive Temperature Coefficient, PTC for short) or a negative resistance behavior (Negative Temperature Coefficient, NTC for short). For example, the sensing element is based on Pt. The sensing element may be a PT100 or a PT500 or a PT1000, for example.

Alternatively, the sensing element may be a thermocouple.

According to a further embodiment, the sensing element is a chip or a surface mounting device, SMD for short. In this case, the sensing element may be a complete sensor. For example, the sensing element comprises circuitry for signal processing.

According to a further embodiment, the power module is configured to transmit measurement signals obtained with the help of the sensing element to an external device. For example, the sensing element is electrically connected to auxiliary terminals which, in the power module, are externally electrically connectable to an external or internal device. The connection to the auxiliary terminals may be via wire bonding. Alternatively, the power module may comprise a wireless communication device, like a Bluetooth device, with which the measurement signals taken with the help of the sensing element are wirelessly transmitted.

The chip-like sensing element may comprise at least one top contact and a bottom contact. The bottom contact may be bonded and electrically connected to the connection element and the top contact element may be electrically connected to a different area of the power module, e.g. by wire-bonding.

Alternatively, the sensing element may comprise two or more contact elements, each of which is electrically connected to further areas of the power module, e.g. by means of wire-bonding.

According to a further embodiment, the power semiconductor device has an edge length of at most 8 mm or at most 5 mm. Thus, the contact side of the power semiconductor device has an area of at most 25 mm². Particularly for such small power semiconductor devices, the positioning of the sensing element on the connection element spaced from the bond section is advantageous. The area on the power semiconductor device for joining of the connection element is smaller, for example.

According to at least one embodiment, the sensing element has dimensions of at most 5 mm.

According to a further embodiment, the power module comprises a housing surrounding the power semiconductor device. For example, the housing surrounds the power semiconductor device at least in lateral directions, i.e. directions parallel to the contact side of the power semiconductor device and/or parallel to a main extension plane of the power module.

The housing may comprise or consist of an electrically isolating material. The housing may at least partially be formed by a frame of a thermoplastic or a thermosetting resin material which may be filled with inorganic particles or fibers. For example, the housing comprises a frame surrounding a cavity and a gel or potting resin filled into the cavity. For example, the power semiconductor device is embedded in and encapsulated by the housing. The housing may be at least partially formed by a molding process, like transfer molding or injection molding.

According to a further embodiment, the power module comprises a baseplate on which the one or more substrates are mounted. The baseplate may be configured as a heatsink. For example, the baseplate comprises cooling ribs and/or cooling fins on the side facing away from the substrate.

The power module may be a device incorporating and electrically and mechanically interconnecting a plurality of power semiconductor devices. The power module may be adapted for processing currents of more than 10 A. The power module may be a low voltage module adapted for processing voltages below 1 kV or may be a medium voltage module adapted for processing voltages between 1 kV and 10 kV.

The power module may be employed in an electrical converter, which, for example, rectifies an AC voltage/current into a DC voltage/current to be supplied to a DC link or a battery, such as a battery of an electric vehicle. It also may be possible that the power module is an inverter which generates an AC voltage/current from a DC voltage/current to be supplied to an electrical motor, such as the motor of an electric vehicle. The inverter may also be used to change the frequency of an AC voltage/current to another frequency of an AC voltage/current. The power module may be used in automotive applications, such as electric cars, motorbikes, buses, off-road construction vehicles, trucks, charging stations or power plants or traction applications.

Next, the method for producing a power module is specified. The method may be configured to produce the power module according to any one of the embodiments described herein. Therefore, all features disclosed for the power module are also disclosed for the method and vice versa.

In at least one embodiment, the method comprises a step of providing a power semiconductor device and a connection element for electrically connecting the power semiconductor device. In a further step, a bond section of the connection element is bonded to the power semiconductor device. In yet a further step, a sensing element is mounted on the connection element in a region spaced from the bond section but close enough to the bond section such that, when the bond section is bonded to the power semiconductor device, a measurand associated with the power semiconductor device is measurable with the help of the sensing element. The power semiconductor device is mounted on and electrically connected to a substrate. The bond section of the connection element is bonded to a contact side of the power semiconductor device in a bond region, wherein the contact side is a top contact side facing away from the substrate. The sensing element is mounted on the connection element such that, in plan view of the contact side, the sensing element is spaced from the bond region. The connection element comprises a flat section running parallel to the contact side. The sensing element is mounted on the flat section and the flat section is arranged at a greater height than the bond section with respect to a top side of the substrate.

The step of bonding the bond section to the power semiconductor device may be done before or after mounting the sensing element. Mounting the sensing element may comprise gluing, soldering or sintering the sensing element to the connection element.

The region for mounting the sensing element is, for example, chosen as a compromise so that, on one side, sufficient space for mounting the sensing element is available on the connection element and, on the other side, a sufficient vicinity to the power semiconductor device is maintained in order to provide reasonable or direct measurements with the sensing element. For example, the sensing element is a temperature sensing element so that, the closer the sensing element is mounted to the bond section, the better the measurements reflect the true temperature of the power semiconductor device. For example, the region where the sensing element is mounted is determined with the help of simulations beforehand.

Hereinafter, the power module and the method for producing a power module will be explained in more detail with reference to drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference signs in all figures.
Figures 1 to 8 show different exemplary embodiments of the power module in different views,
Figures 9 and 10 show temperature diagrams,
Figure 11 shows a flowchart of an exemplary embodiment of the method for producing a power module.

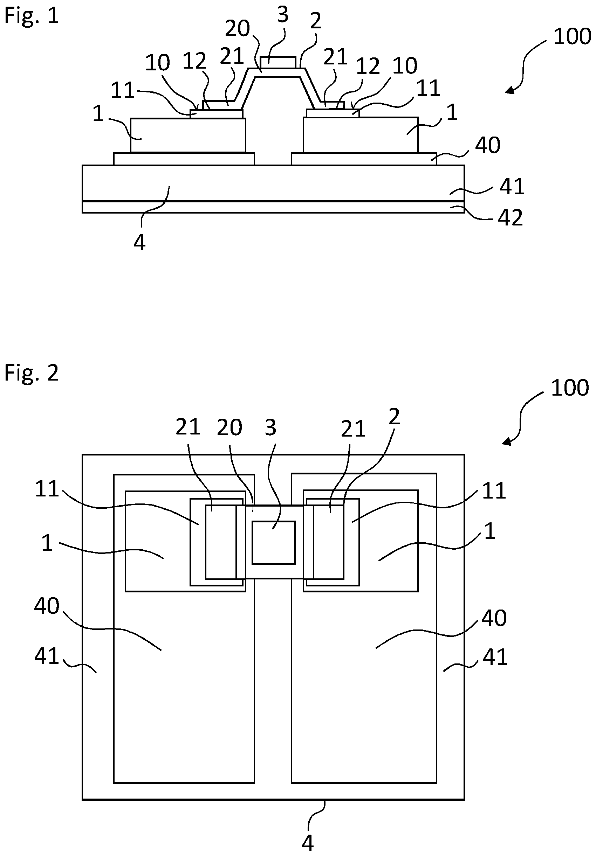

Figure 1 shows a first exemplary embodiment of the power module 100 in cross-sectional view. The power module 100 comprises a substrate 4 with a top metallization 40, a bottom metallization 42 and an electrically isolating layer 41 therebetween. The top metallization 40 is segmented into different segments.

Power semiconductor devices 1 are mounted onto and electrically connected with the different segments of the top metallization 40. For example, the power semiconductor devices 1 are bonded onto the top metallization 40 by means of soldering, gluing or sintering. By way of example, the power semiconductor devices 1 are MOSFETs or IGBT or diodes.

Top contact sides 10 of the power semiconductor devices 1 face away from the substrate 4. The top contact sides 10 are at least partially formed by a top contact element 11 of the respective power semiconductor device 1. A connection element 2 is bonded and electrically connected to each of these top contact elements 11 so that the connection element 2 electrically connects the power semiconductor devices 1.

In the exemplary embodiment of figure 1, the connection element 2 comprises two bond sections 21 at opposite ends. Each bond section 21 is bonded to one of the power semiconductor devices 1. Firm bonds are thereby established in a respective bond region 12. The connection element 2 is, for example, a clip being a pre-bended, rigid metal sheet. The bond sections 21 form feet of the clip 2.

The connection element 2 further comprises a flat section 20 which runs parallel to the top sides 10 or parallel to a main extension plane of the substrate 4, respectively. A sensing element 3 is mounted on a flat surface of the flat section 20. The flat surface faces away from the substrate 4. Thus, the sensing element 3 is spaced apart from the bond sections 21 of the connection element 2.

Intermediate sections of the connection element 2 are formed between the bond sections 21 and the flat section 20. The intermediate sections run, e.g., obliquely to the contact sides 10. As a consequence of this the flat section 20, and accordingly the sensing element 3, are arranged at a greater height than the bond sections 21.

The sensing element 3 is, for example, configured for temperature measurement. Due to the arrangement of the sensing element 3 on the connection element 2, the sensing element 3 is close to the power semiconductor devices 1 and thermally well coupled thereto. This enables a very accurate measurement of the temperature of the power semiconductor devices 1 without large time delay.

The sensing element 3 is, for example, a PT100 element, a NTC/PTC or a thermocouple. Alternatively, the sensing element 3 could be a whole temperature sensor 3, e.g. in the form of a chip or SMD.

Figure 2 shows the power module 100 of figure 1 in a plan view onto the contact sides 10 or the top side of the substrate 4, respectively. As can be seen here, the sensing element 3 is completely arranged within the connection element 2. Thus, in lateral directions, parallel to the top sides 10, the sensing element 3 does not project beyond the connection element 2. Furthermore, the sensing element 3 is spaced from the bond regions 12 and even from the power semiconductor devices 1 themselves. Particularly, in this plan view, the sensing element 3 is arranged between the two power semiconductor devices 1.

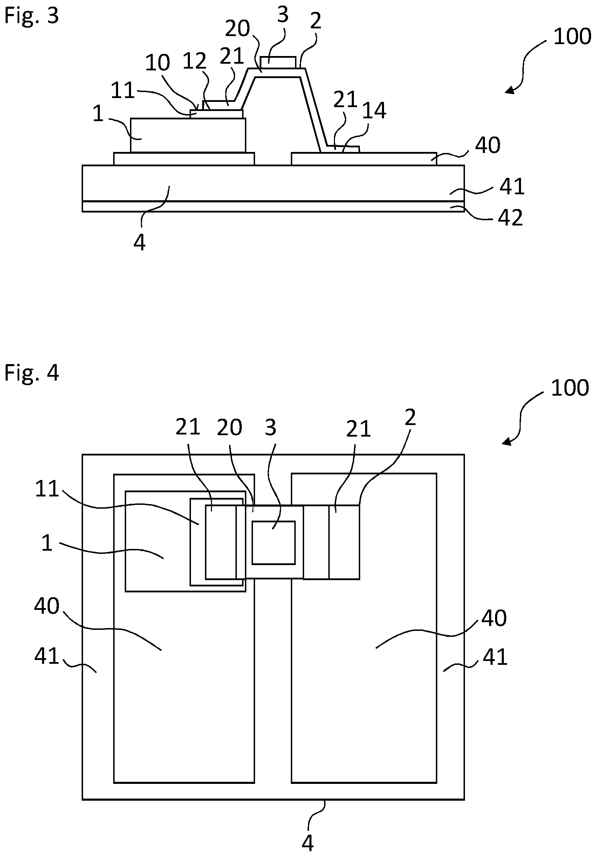

Figures 3 and 4 show a further exemplary embodiment of the power module 100, again in cross-sectional view (figure 3) and in plan view (figure 4). In contrast to the previous exemplary embodiment, the connection element 2 now electrically connects a top side contact element 11 with a segment of the top metallization 40 of the substrate 4. For this purpose, the connection element 2, namely bond sections 21 thereof, is bonded to the contact element 11 in a bond region 12 at one side and to the substrate 4 in a bond region 14 at the other side. In contrast to what is shown in the figures, the opposite bond sections 21 may also lie on different heights.

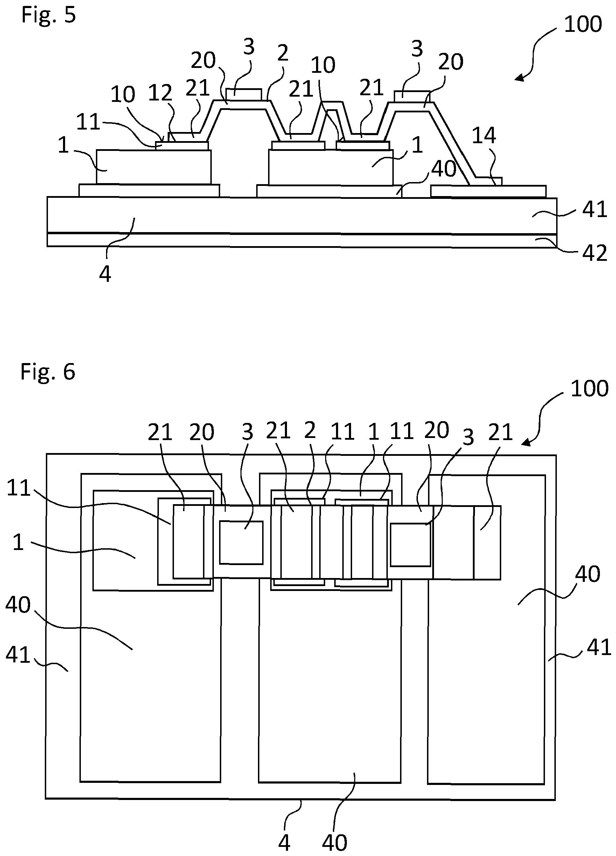

In the exemplary embodiment of figures 5 (cross-sectional view) and 6 (plan view), the substrate 4 has a top metallization 40 with three segments. On a first segment, a first power semiconductor device 1 is mounted and, on a second segment, a second power semiconductor device 1 is mounted. The connection element 2 has four bond sections 21 each bonded to a different area. Foot-like bond sections 21 are bonded and electrically connected to the first power semiconductor device 1 and to a third segment of the top metallization 40. Two stitched or punched bond sections 21 are bonded and electrically connected to the second power semiconductor device 1. As in the previous exemplary embodiments, the connection element 2 is a clip formed in one piece.

The connection element 2 comprises two flat sections 21 and, on each flat section 20, a sensing element 3, e.g. a temperature sensing element, is mounted. As can be seen in figure 6, the sensing elements 3 are again spaced from the bond sections 21 and do not overlap with the power semiconductor devices 1 or the bond regions 12, respectively.

In the shown exemplary embodiments, the connection element 2 is always realized as a clip. Instead of a clip, however, ribbons or wires could be used. The sensing element 3 does not need to be configured for temperature measurement. It could additionally or alternatively be configured for the measurement of other measurands, like humidity or current.

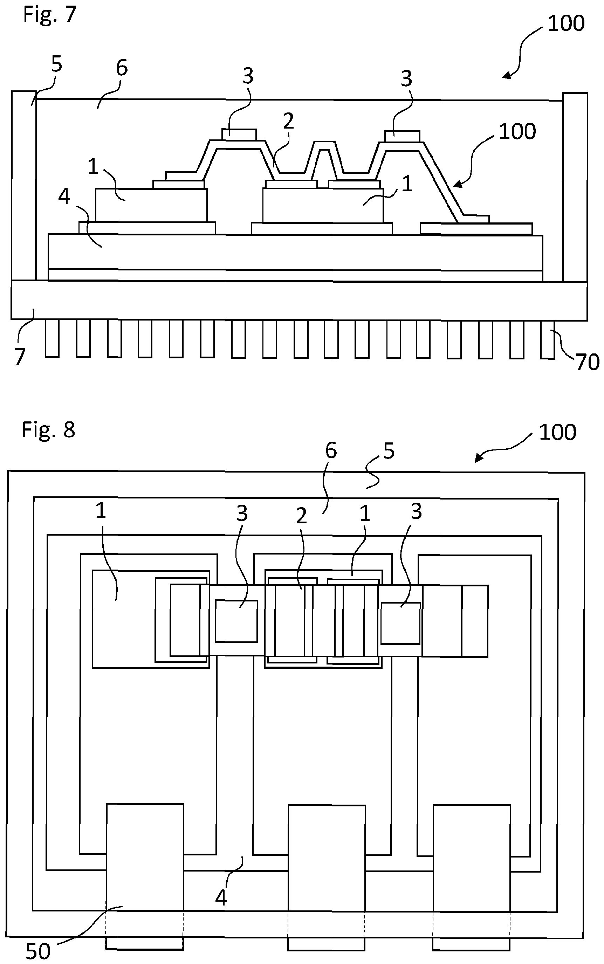

Figures 7 and 8 show an exemplary embodiment of a power module 100 in which further components of the power module 100 are illustrated. The power module 100 comprises a baseplate 7 having cooling fins 70. The substrate with the power semiconductor devices 1 is laterally surrounded by a frame 5 of a housing. The frame 5 is, e.g., formed of a resin. The cavity formed by the frame is further filled with a gel or a resin 6 so that the power semiconductor devices 1, the connection element 2 and the sensing elements 3 are embedded in the gel 6. The frame 5 and the gel or resin 6 together form a housing 5, 6 of the power module 100.

It can be seen in figure 8 that the power module 100 further comprises terminals 50 which project out of the housing 5, 6.

The power module 100 is electrically connectable via the terminals 50.

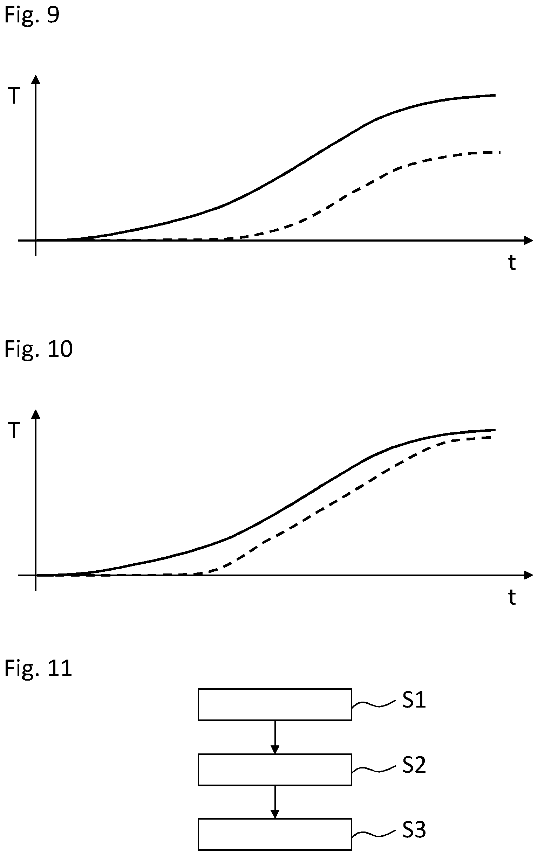

Figures 9 and 10 show the temperature T as a function of time t for a power semiconductor device for which operation is started (solid line) and the resulting temperature measured with a sensing element in the vicinity of the power semiconductor device (dashed line). The case is shown in figure 9 wherein the sensing element is mounted on a separate segment of a top metallization of a substrate next to the power semiconductor device. As can be seen, the temperature measured with the sensing element rises with a considerable delay compared to the temperature of the power semiconductor device. Moreover, the maximum measured temperature is well below the maximum temperature of the power semiconductor device. This is particularly due to the long thermal path along the substrate.

In figure 10 the case is shown where the sensing element is mounted as in the exemplary embodiment of, for example, figures 3 and 4, i.e. on a connection element bonded and electrically connected to the power semiconductor device. Due to the vicinity (shorter thermal path) to the power semiconductor device and the good thermal conductivity of the connection element, the delay in the rise of the temperature is much smaller than in figure 9 and the maximum measured temperature is much closer to the maximum temperature of the power semiconductor device.

Figure 11 shows a flowchart of an exemplary embodiment of the method for producing a power module. In a step S1, a power semiconductor device and a connection element for electrically connecting the power semiconductor device are provided. In a step S2, a bond section of the connection element is bonded to the power semiconductor device. In a step S3, a sensing element is mounted on the connection element in a region spaced from the bond section but close enough to the bond section such that, when the bond section is bonded to the power semiconductor device, a measurand associated with the power semiconductor device is measurable with the help of the sensing element. The order of steps S2 and S3 may be interchanged.

### Reference Signs

- 1: power semiconductor device
- 2: connection element
- 3: sensing element
- 4: substrate
- 5: frame
- 6: gel or resin
- 7: baseplate
- 10: contact side
- 11: contact element
- 12: bond region
- 14: bond region
- 20: flat section
- 21: bond section
- 40: top metallization
- 41: electrically isolating layer
- 42: bottom metallization
- 50: terminal
- 70: cooling fins
- 100: power module
- Si: method steps

## Claims

1. Power module (100) comprising
- a substrate (4),
- a power semiconductor device (1) mounted on and electrically connected to the substrate (4),
- a connection element (2) for electrically connecting the power semiconductor device (1),
- a sensing element (3) for measuring a measurand, wherein
- a bond section (21) of the connection element (2) is bonded to and electrically connected with the power semiconductor device (1),
- the sensing element (3) is mounted on the connection element (2) and spaced from the bond section (21),
- the bond section (21) of the connection element (2) is bonded to a contact side (10) of the power semiconductor device (1) in a bond region (12), wherein the contact side (10) is a top contact side facing away from the substrate (4),
- the sensing element (3) is mounted on the connection element (2) such that, in plan view of the contact side (10), the sensing element (3) is spaced from the bond region (12),
- the connection element (2) comprises a flat section (20) running parallel to the contact side (10),
- the sensing element (3) is mounted on the flat section (20), **characterized in that**
- the flat section (20) is arranged at a greater height than the bond section (21) with respect to a top side of the substrate (4).

2. Power module (100) according to claim 1, wherein
- the sensing element (3) is a temperature sensing element for measuring a temperature.

3. Power module (100) according to any one of the preceding claims, wherein
- the connection element (2) is one of: a ribbon, a wire, a terminal, a clip.

4. Power module (100) according to any one of the preceding claims, wherein
- in plan view of the contact side (10), the sensing element (3) is spaced from the power semiconductor device (1) and/or from the active region of the power semiconductor device.

5. Power module (100) according to any one of the preceding claim, wherein
- the connection element (2) electrically connects the power semiconductor device (1) with one or more further elements (1, 4) of the power module (100).

6. Power module (100) according to claim 5, wherein
- the further element (1, 4) is a further power semiconductor device (1) or a substrate (4) or a terminal.

7. Power module (100) according to any one of the preceding claims, wherein
- the power semiconductor device (1) is a transistor or a thyristor or a diode.

8. Power module (100) according to any one of the preceding claims, wherein
- the power semiconductor device (1) is based on at least one of: silicon, silicon carbide, gallium nitride.

9. Power module (100) according to claim 2 or any one of claims 3 to 8 in its dependency of claim 2, wherein
- the sensing element (3) is a resistive element.

10. Power module (100) according to any one of the preceding claims, wherein
- the sensing element (3) is a chip or an SMD.

11. Power module (100) according to any one of the preceding claims, wherein
- the power semiconductor device (1) has an edge length of at most 8 mm,
- a distance between the sensing element (3) and the bond section (21) is at most 15 mm.

12. Method for producing a power module, comprising
- providing a power semiconductor device (1) and a connection element (2) for electrically connecting the power semiconductor device (1),
- bonding a bond section (21) of the connection element (2) to the power semiconductor device (1),
- mounting a sensing element (3) on the connection element (2) in a region spaced from the bond section (21) but close enough to the bond section (21) such that, when the bond section (21) is bonded to the power semiconductor device (1), a measurand associated with the power semiconductor device (1) is measurable with the help of the sensing element (3), wherein
- the power semiconductor device (1) is mounted on and electrically connected to a substrate (4),
- the bond section (21) of the connection element (2) is bonded to a contact side (10) of the power semiconductor device (1) in a bond region (12), wherein the contact side (10) is a top contact side facing away from the substrate (4),
- the sensing element (3) is mounted on the connection element (2) such that, in plan view of the contact side (10), the sensing element (3) is spaced from the bond region (12),
- the connection element (2) comprises a flat section (20) running parallel to the contact side (10),
- the sensing element (3) is mounted on the flat section (20), **characterized in that**
- the flat section (20) is arranged at a greater height than the bond section (21) with respect to a top side of the substrate (4).

## Patentansprüche

1. Leistungsmodul (100), umfassend:
- ein Substrat (4),
- ein Leistungshalbleiterbauelement (1), das auf das Substrat (4) montiert und mit diesem elektrisch verbunden ist,
- ein Verbindungselement (2) zum elektrischen Verbinden des Leistungshalbleiterbauelements (1),
- ein Messelement (3) zum Messen einer Messgröße, wobei
- ein Bondabschnitt (21) des Verbindungselements (2) an das Leistungshalbleiterbauelement (1) gebondet und mit diesem elektrisch verbunden ist,
- das Messelement (3) auf das Verbindungselement (2) montiert und vom Bondabschnitt (21) beabstandet ist,
- der Bondabschnitt (21) des Verbindungselements (2) in einem Bondgebiet (12) an eine Kontaktseite (10) des Leistungshalbleiterbauelements (1) gebondet ist, wobei die Kontaktseite (10) eine vom Substrat (4) abgewandte obere Kontaktseite ist,
- das Messelement (3) so auf das Verbindungselement (2) montiert ist, dass in einer Draufsicht der Kontaktseite (10) das Messelement (3) vom Bondgebiet (12) beabstandet ist,
- das Verbindungselement (2) einen flachen Abschnitt (20) umfasst, der parallel zur Kontaktseite (10) verläuft,
- das Messelement (3) auf den flachen Abschnitt (20) montiert ist, **dadurch gekennzeichnet, dass**
- der flache Abschnitt (20) bezüglich einer Oberseite des Substrats (4) in einer größeren Höhe angeordnet ist als der Bondabschnitt (21).

2. Leistungsmodul (100) nach Anspruch 1, wobei
- das Messelement (3) ein Temperaturmesselement zum Messen der Temperatur ist.

3. Leistungsmodul (100) nach einem der vorhergehenden Ansprüche, wobei
- das Verbindungselement (2) eines aus Folgenden ist: ein Band, ein Draht, ein Anschluss, eine Klammer.

4. Leistungsmodul (100) nach einem der vorhergehenden Ansprüche, wobei
- in der Draufsicht der Kontaktseite (10) das Messelement (3) vom Leistungshalbleiterbauelement (1) und/oder vom aktiven Gebiet des Leistungshalbleiterbauelements beabstandet ist.

5. Leistungsmodul (100) nach einem der vorhergehenden Ansprüche, wobei
- das Verbindungselement (2) das Leistungshalbleiterbauelement (1) mit einem oder weiteren Elementen (1, 4) des Leistungsmoduls (100) elektrisch verbindet.

6. Leistungsmodul (100) nach Anspruch 5, wobei
- das weitere Element (1, 4) ein weiteres Leistungshalbleiterbauelement (1) oder ein Substrat (4) oder ein Anschluss ist.

7. Leistungsmodul (100) nach einem der vorhergehenden Ansprüche, wobei
- das Leistungshalbleiterbauelement (1) ein Transistor oder ein Thyristor oder eine Diode ist.

8. Leistungsmodul (100) nach einem der vorhergehenden Ansprüche, wobei
- das Leistungshalbleiterbauelement (1) auf mindestens einem aus Folgenden basiert: Silicium, Siliciumcarbid, Galliumnitrid.

9. Leistungsmodul (100) nach Anspruch 2 oder einem der Ansprüche 3 bis 8 in Abhängigkeit von Anspruch 2, wobei
- das Messelement (3) ein Widerstandselement ist.

10. Leistungsmodul (100) nach einem der vorhergehenden Ansprüche, wobei
- das Messelement (3) ein Chip oder ein SMD ist.

11. Leistungsmodul (100) nach einem der vorhergehenden Ansprüche, wobei
- das Leistungshalbleiterbauelement (1) eine Kantenlänge von höchstens 8 mm aufweist,
- ein Abstand zwischen dem Messelement (3) und dem Bondabschnitt (21) höchstens 15 mm beträgt.

12. Verfahren zur Herstellung eines Leistungsmoduls, umfassend
- Bereitstellen eines Leistungshalbleiterbauelements (1) und eines Verbindungselements (2) zum elektrischen Verbinden des Leistungshalbleiterbauelements (1),
- Bonden eines Bondabschnitts (21) des Verbindungselements (2) an das Leistungshalbleiterbauelement (1),
- Montieren eines Messelements (3) auf das Verbindungselement (2) in einem Gebiet, das vom Bondabschnitt (21) beabstandet ist, aber nahe genug am Bondabschnitt (21) liegt, so dass eine Messgröße des Leistungshalbleiterbauelements (1) mithilfe des Messelements (3) messbar ist, wenn der Bondabschnitt (21) an das Leistungshalbleiterbauelement (1) gebondet ist, wobei
- das Leistungshalbleiterbauelement (1) auf das Substrat (4) montiert und mit diesem elektrisch verbunden wird,
- der Bondabschnitt (21) des Verbindungselements (2) in einem Bondgebiet (12) an eine Kontaktseite (10) des Leistungshalbleiterbauelements (1) gebondet wird, wobei die Kontaktseite (10) eine obere Kontaktseite ist, die vom Substrat (4) abgewandt ist,
- das Messelement (3) so auf das Verbindungselement (2) montiert ist, dass in einer Draufsicht der Kontaktseite (10) das Messelement (3) vom Bondgebiet (12) beabstandet ist,
- das Verbindungselement (2) einen flachen Abschnitt (20) umfasst, der parallel zur Kontaktseite (10) verläuft,
- das Messelement (3) auf den flachen Abschnitt (20) montiert ist, **dadurch gekennzeichnet, dass**
- der flache Abschnitt (20) bezüglich einer Oberseite des Substrats (4) in einer größeren Höhe angeordnet ist als der Bondabschnitt (21).

## Revendications

1. Module de puissance (100) comprenant :
- un substrat (4),
- un dispositif à semi-conducteur de puissance (1) monté sur le substrat (4) et connecté électriquement à celui-ci,
- un élément de connexion (2) pour connecter électriquement le dispositif à semi-conducteur de puissance (1),
- un élément de détection (3) pour mesurer une grandeur mesurée, dans lequel :
- une section de liaison (21) de l'élément de connexion (2) est liée et connectée électriquement au dispositif à semi-conducteur de puissance (1),
- l'élément de détection (3) est monté sur l'élément de connexion (2) et espacé de la section de liaison (21),
- la section de liaison (21) de l'élément de connexion (2) est liée à une face de contact (10) du dispositif à semi-conducteur de puissance (1) dans une zone de liaison (12), la face de contact (10) étant une face de contact supérieure orientée à l'opposé du substrat (4),
- l'élément de détection (3) est monté sur l'élément de connexion (2) de telle sorte que, en vue de dessus de la face de contact (10), l'élément de détection (3) est espacé de la zone de liaison (12),
- l'élément de connexion (2) comprend une section plate (20) s'étendant parallèlement à la face de contact (10),
- l'élément de détection (3) est monté sur la section plate (20), **caractérisé en ce que** :
- la section plate (20) est disposée à une hauteur supérieure à celle de la section de liaison (21) par rapport à la face supérieure du substrat (4).

2. Module de puissance (100) selon la revendication 1, dans lequel :
- l'élément de détection (3) est un élément de détection de température pour mesurer une température.

3. Module de puissance (100) selon l'une quelconque des revendications précédentes, dans lequel :
- l'élément de connexion (2) est l'un des éléments suivants : un ruban, un fil, une borne, un clip.

4. Module de puissance (100) selon l'une quelconque des revendications précédentes, dans lequel :
- en vue de dessus de la face de contact (10), l'élément de détection (3) est éloigné du dispositif à semi-conducteur de puissance (1) et/ou de la zone active du dispositif à semi-conducteur de puissance.

5. Module de puissance (100) selon l'une quelconque des revendications précédentes, dans lequel :
- l'élément de connexion (2) connecte électriquement le dispositif à semi-conducteur de puissance (1) à un ou plusieurs autres éléments (1, 4) du module de puissance (100).

6. Module de puissance (100) selon la revendication 5, dans lequel :
- l'élément supplémentaire (1, 4) est un autre dispositif à semi-conducteur de puissance (1) ou un substrat (4) ou une borne.

7. Module de puissance (100) selon l'une quelconque des revendications précédentes, dans lequel :
- le dispositif à semi-conducteur de puissance (1) est un transistor, un thyristor ou une diode.

8. Module de puissance (100) selon l'une quelconque des revendications précédentes, dans lequel :
- le dispositif à semi-conducteur de puissance (1) est basé sur au moins l'un des éléments suivants : du silicium, du carbure de silicium, du nitrure de gallium.

9. Module de puissance (100) selon la revendication 2 ou l'une quelconque des revendications 3 à 8 dans sa dépendance à la revendication 2, dans lequel :
- l'élément de détection (3) est un élément résistif.

10. Module de puissance (100) selon l'une quelconque des revendications précédentes, dans lequel :
- l'élément de détection (3) est une puce ou un SMD.

11. Module de puissance (100) selon l'une quelconque des revendications précédentes, dans lequel :
- le dispositif à semi-conducteur de puissance (1) a une longueur de bord d'au plus 8 mm,
- la distance entre l'élément sensible (3) et la section de liaison (21) est d'au plus 15 mm.

12. Procédé de fabrication d'un module de puissance, comprenant les étapes suivantes :
- fournir un dispositif à semi-conducteur de puissance (1) et un élément de connexion (2) pour connecter électriquement le dispositif à semi-conducteur de puissance (1),
- coller une section de liaison (21) de l'élément de connexion (2) au dispositif à semi-conducteur de puissance (1),
- monter un élément de détection (3) sur l'élément de connexion (2) dans une région espacée de la section de liaison (21) mais suffisamment proche de la section de liaison (21) de manière à ce que, lorsque la section de liaison (21) est collée au dispositif à semi-conducteur de puissance (1), une grandeur mesurée associée au dispositif à semi-conducteur de puissance (1) puisse être mesurée à l'aide de l'élément de détection (3), dans lequel :
- le dispositif à semi-conducteur de puissance (1) est monté sur un substrat (4) et connecté électriquement à celui-ci,
- la section de liaison (21) de l'élément de connexion (2) est liée à une face de contact (10) du dispositif semi-conducteur de puissance (1) dans une zone de liaison (12), la face de contact (10) étant une face de contact supérieure orientée à l'opposé du substrat (4),
- l'élément de détection (3) est monté sur l'élément de connexion (2) de telle sorte que, en vue de dessus de la face de contact (10), l'élément de détection (3) est espacé de la zone de liaison (12),
- l'élément de connexion (2) comprend une section plate (20) parallèle à la face de contact (10),
- l'élément de détection (3) est monté sur la section plate (20), **caractérisé en ce que** :
- la section plate (20) est disposée à une hauteur supérieure à celle de la section de liaison (21) par rapport à la face supérieure du substrat (4).
